# EUROPÄISCHE PATENTSCHRIFT

(11) **EP 3 997 420 B1**
(45) Veröffentlichungstag und Bekanntmachung des Hinweises auf die Patenterteilung: **28.06.2023**
(21) Anmeldenummer: 20733962.3
(22) Anmeldetag: 18.06.2020
(51) Int. Cl.: G01D 11/24, H05K 7/14

(54) **GEHÄUSEMODUL UND FELDGERÄT**
HOUSING MODULE AND FIELD DEVICE
MODULE DE BOÎTIER ET APPAREIL DE TERRAIN

(30) Priorität: 11.07.2019 DE 102019118805
(43) Veröffentlichungstag der Anmeldung: 18.05.2022
(73) Patentinhaber: Endress + Hauser Flowtec AG, 4153 Reinach (CH)
(72) Erfinder: BEISSERT, Markus, 79424 Auggen (DE); MÜLLER, Harald, 36043 Fulda (DE); BINZER, Martin, 4222 Zwingen (CH)
(74) Vertreter: Hahn, Christian
(86) Internationale Anmeldenummer: PCT/EP2020/066961
(87) Internationale Veröffentlichungsnummer: WO 2021/004755

(56) Entgegenhaltungen:
- WO-A1-2011/160949
- DE-A1- 10 126 654
- DE-A1-102014 106 540

## Beschreibung

Die Erfindung betrifft ein Gehäusemodul eines Feldgeräts der Mess- und Automatisierungstechnik und ein solches Feldgerät, wobei das Gehäusemodul mindestens zwei Gehäusekammern aufweist, wobei die Gehäusekammern durch eine Trennwand getrennt sind, wobei das Gehäusemodul die Zündschutzart Ex-d erfüllt.

Die WO2011160949A1 offenbart ein solches Gehäusemodul mit einer solchen Trennwand, wobei in einer ersten Gehäusekammer eine Mess- und Betriebselektronik angeordnet ist, und wobei in einer zweiten Gehäusekammer eine Anschlusselektronik angeordnet ist. Eine elektrische Verbindung ist dabei durch eine Öffnung der Trennwand geführt, wobei die Öffnung mit einem Verguss gefüllt ist um Anforderungen hinsichtlich der Zündschutzart Ex-d zu erfüllen. Die Trennwand selbst ist dabei als Einschraubverschluss lösbar befestigt im Gehäusemodul angeordnet und erfüllt auch die Anforderungen der Zündschutzart Ex-d.

Das Einschrauben einer Trennwand erschwert die Fertigung und Montage des Gehäusemoduls und erhöht somit Gesamtkosten des Gehäusemoduls, da eine helixförmige Nut als Gewinde in eine Gehäusewandung eingebracht und die Trennwand umständlich im Gehäuse eingeschraubt werden muss.

Die DE10126654A1 zeigt ein Gehäuse mit einem Anzeigemodul und zwei Öffnungen, wobei das Anzeigemodul in einer der beiden Öffnungen eingesetzt ist und die jeweils andere Öffnung durch eine Bodenplatte verschlossen ist.

Die DE102014106540A1 zeigt ein Feldgerät mit einem rohrförmigen Gehäusekörper, bei welchem ein Schließelement den Gehäusekörper im Bereich einer Stirnfläche verschließt.

Aufgabe der Erfindung ist es daher ein Gehäusemodul und ein Feldgerät mit einem solchen Gehäusemodul vorzuschlagen, bei welchem Fertigung sowie Wartung bei Einhaltung der Anforderungen der Zündschutzart Ex-d vereinfacht ist.

Die Aufgabe wird gelöst durch ein Gehäusemodul gemäß dem unabhängigen Anspruch 1 sowie durch ein Feldgerät gemäß dem unabhängigen Anspruch 12.

Ein erfindungsgemäßes Gehäusemodul umfasst ein Gehäuse mit einer Gehäusewandung und einer ersten Gehäusekammer sowie einer zweiten Gehäusekammer, wobei die Gehäusekammern durch eine Trennwand getrennt sind,
wobei in der ersten Gehäusekammer eine Mess-/Betriebselektronik des Feldgeräts angeordnet ist, und wobei in der zweiten Gehäusekammer eine Anschlusselektronik zum Anschließen von Leitungen zur Energieversorgung des Feldgeräts und/oder zum Austausch von Daten angeordnet ist,
wobei die Gehäusewandung auf einer Innenseite einen ersten Wandungsbereich eingerichtet zur Aufnahme der Trennwand aufweist, wobei der erste Wandungsbereich von einer Mantelfläche der Trennwand durch einen die Trennwand umgebenden Spalt getrennt ist, wobei der Spalt in einer einen Längsschnitt der Trennwand enthaltende Ebene eine Pfadlänge aufweist,
wobei ein Verhältnis Spaltbreite zu Pfadlänge kleiner ist als 0.05, und insbesondere kleiner ist als 0.025 und bevorzugt kleiner ist als 0.02 und Anforderungen der EX-d-Norm nach IEC60079-1 von 2014-06; EN60079-1 von 2014-06 entspricht,
wobei eine Sicherungsvorrichtung dazu vorgesehen ist, einen Bewegungsspielraum der Trennwand in Richtung zweite Gehäusekammer einzuschränken,
dadurch gekennzeichnet, dass die Gehäusewandung auf der Innenseite einen zweiten Wandungsbereich aufweist, wobei in dem zweiten Wandungsbereich die Gehäusewandung zumindest abschnittsweise zumindest eine Nut aufweist, wobei die Nut parallel zu einer Querschnittsebene der Trennwand verläuft,
wobei die Sicherungsvorrichtung eine Eingriffsvorrichtung aufweist, welche dazu eingerichtet ist, in die Nut einzugreifen,
wobei die Eingriffsvorrichtung mindestens zwei Eingriffselemente aufweist, wobei die Eingriffselemente bei Montage der Sicherungsvorrichtung in der zweiten Gehäusekammer von einer Ausgangsposition in eine Zielposition in eine zugehörige Nut geführt werden,
wobei die Eingriffselemente in der Zielposition mittels einer Befestigungsvorrichtung fixierbar sind.

In einer Ausgestaltung weist die Sicherungsvorrichtung eine Haltevorrichtung mit einem Grundkörper auf, welche dazu eingerichtet ist, die Eingriffselemente in der Ausgangsposition beweglich zu halten, und wobei die Haltevorrichtung dazu eingerichtet ist, die Eingriffselemente bei Montage in die Zielposition zu führen.

In einer Ausgestaltung weist jedes Eingriffselement zumindest zwei Einschnitte mit jeweils einem ersten, der zugehörigen Nut zugewandten Einschnittende und einem zweiten, der zugehörigen Nut abgewandten Einschnittende auf,
wobei die Haltevorrichtung für jeden Einschnitt mindestens einen ersten Führungskörper aufweist, wobei die ersten Führungskörper das zugehörige Eingriffselement von einer der Ausgangsposition zugewandten Seite des Eingriffselements im Bereich des zugehörigen Einschnitts umgreifen,
wobei jeder erste Führungskörper einen Führungskopf aufweist, wobei der Führungskopf in den zugehörigen Einschnitt eingreift und dazu eingerichtet ist, über das zweite Einschnittende eine Führung des Eingriffselements zu bewirken.

In einer Ausgestaltung weist der Führungskopf auf einer dem zugehörigen zweiten Einschnittende eine erste schräge Fläche auf, welche bezüglich der Querschnittsebene der Trennwand schräg verläuft,
wobei die erste schräge Fläche dazu eingerichtet ist, bei Bewegung des Eingriffselements in seine Zielposition der Bewegung eine Komponente in Richtung des Grundkörpers zu vermitteln.

In einer Ausgestaltung weist die Haltevorrichtung für jedes Eingriffselement mindestens einen zweiten Führungskörper auf, wobei der zweite Führungskörper aus dem Grundkörper hervorsteht und jeweils mindestens eine zweite schräge Fläche aufweist,
wobei die zweite schräge Fläche bezüglich der Querschnittsebene der Trennwand schräg verläuft,
wobei die zweite schräge Fläche dazu eingerichtet ist, bei Bewegung eines zugehörigen Eingriffselements in seine Zielposition der Bewegung eine Komponente parallel zur Querschnittsfläche der Trennwand in Richtung der Gehäusewandung zu vermitteln.

In einer Ausgestaltung weist die Trennwand für jedes Eingriffselement mindestens eine erste Bohrung mit einem Innengewinde auf,
wobei die Eingriffselemente jeweils mindestens eine Durchgangsbohrung aufweisen,
wobei die Durchgangsbohrungen bei Positionierung der Eingriffselemente in ihren Zielpositionen jeweils koaxial zu einer ersten Bohrung sind,
wobei die Eingriffselemente mittels Schrauben in der Zielposition fixiert sind,
wobei die Schrauben jeweils in das Gewinde einer ersten Bohrung eingreifen.

In einer Ausgestaltung weist die Haltevorrichtung für jede Schraube eine Aufnahmevorrichtung zur Aufnahme eines Schraubenkopfs der jeweiligen Schraube auf,
wobei bei Fixieren eines Eingriffselements in seiner Zielposition mittels einer Schraube der Schraubenkopf der jeweiligen Schraube in der Aufnahmevorrichtung versenkt wird.

In einer Ausgestaltung ist die Haltevorrichtung mittels Spritzgießen aus einem Kunststoff wie beispielsweise einem Polycarbonat gefertigt.

In einer Ausgestaltung sind die Eingriffselemente jeweils aus einem Metall oder einer Legierung wie beispielsweise dem Edelstahl 1.4301 gefertigt.

In einer Ausgestaltung weist die Trennwand zumindest eine Aussparung auf, welche dazu eingerichtet ist, die ersten Führungskörper zumindest teilweise aufzunehmen.

In einer Ausgestaltung weist die Trennwand eine Durchführung eingerichtet für eine elektrische Verbindung zwischen Mess-/Betriebselektronik und Anschlusselektronik auf.

Ein erfindungsgemäßes Feldgerät der Mess- und Automatisierungstechnik umfasst:
Ein Gehäusemodul nach einem der Ansprüche 1 bis 11;
Einen Messumformer zum Erfassen mindestens einer Messgröße und zum Bereitstellen eines die Messgröße repräsentierenden Messsignals,
wobei die Mess-/Betriebselektronik dazu eingerichtet ist, mittels des Messsignals Messwerte der Messgröße zu bestimmen und bereitzustellen.

Im Folgenden wird die Erfindung anhand von Ausführungsbeispielen beschrieben.
Fig. 1 skizziert den Aufbau eines erfindungsgemäßen Gehäusemoduls;
Fig. 2 a) zeigt eine Aufsicht auf eine beispielhafte erfindungsgemäße Sicherungsvorrichtung und einen Schnitt durch einen Ausschnitt;

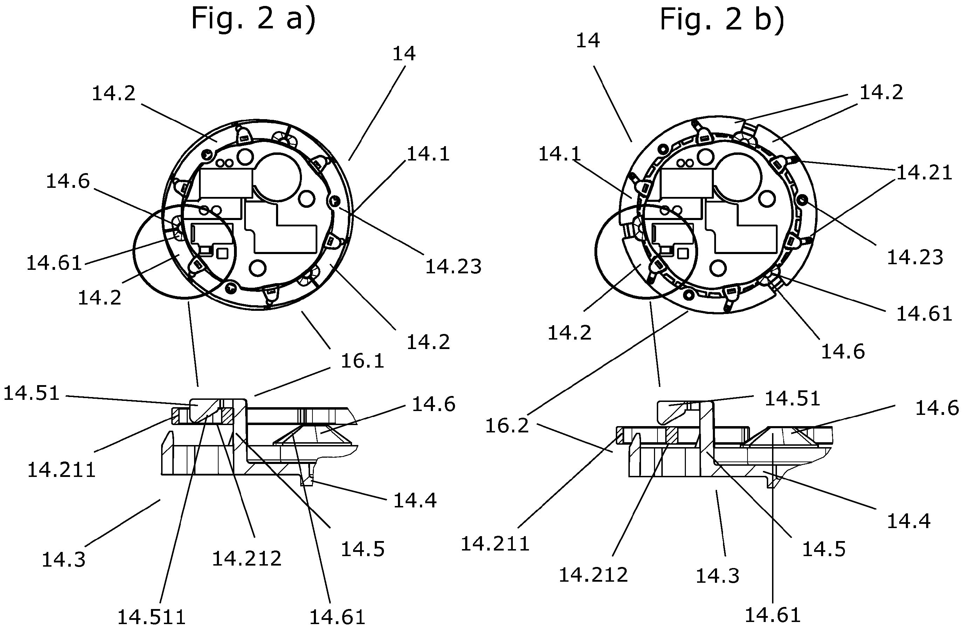

Fig. 2 b) zeigt eine weitere Aufsicht auf die in Fig. 2 a) gezeigte Sicherungsvorrichtung und einen Schnitt durch einen Ausschnitt.

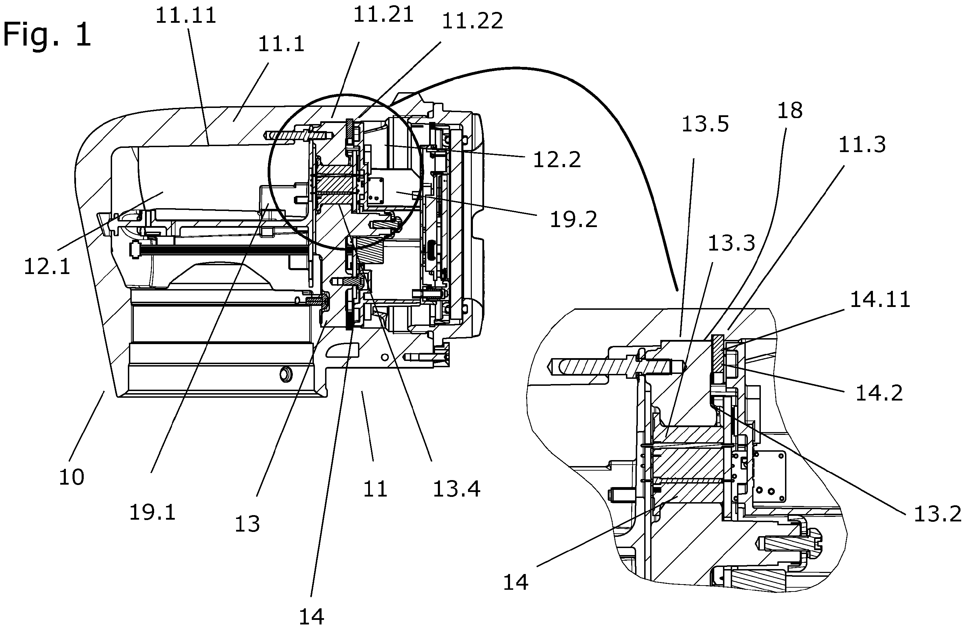

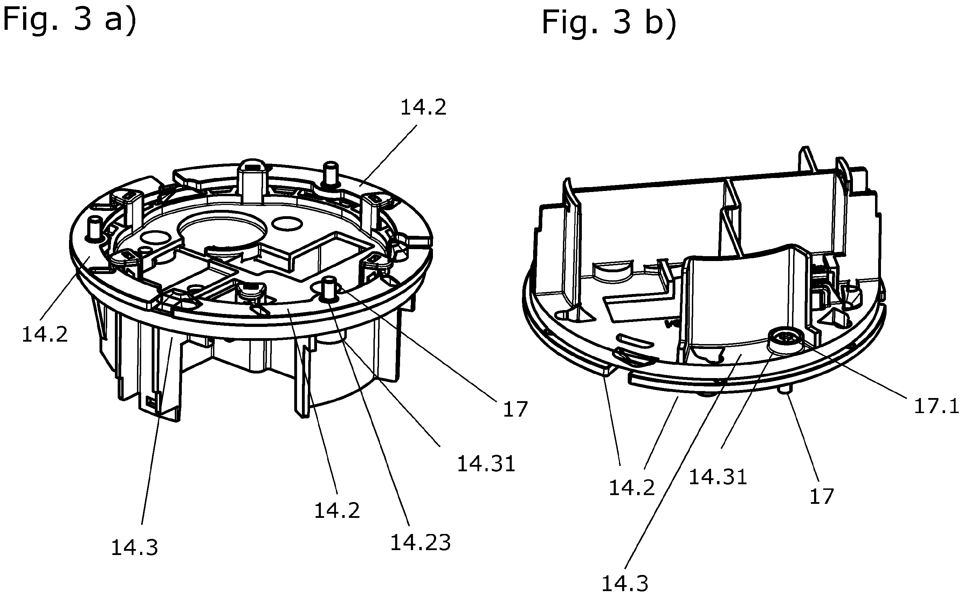

Fig. 3 a) und Fig. 3 b) zeigen jeweils eine Aufsicht auf die in Figs. 1 und 2 a) und 2 b) gezeigte Sicherungsvorrichtung mit Eingriffselementen in Zielposition.

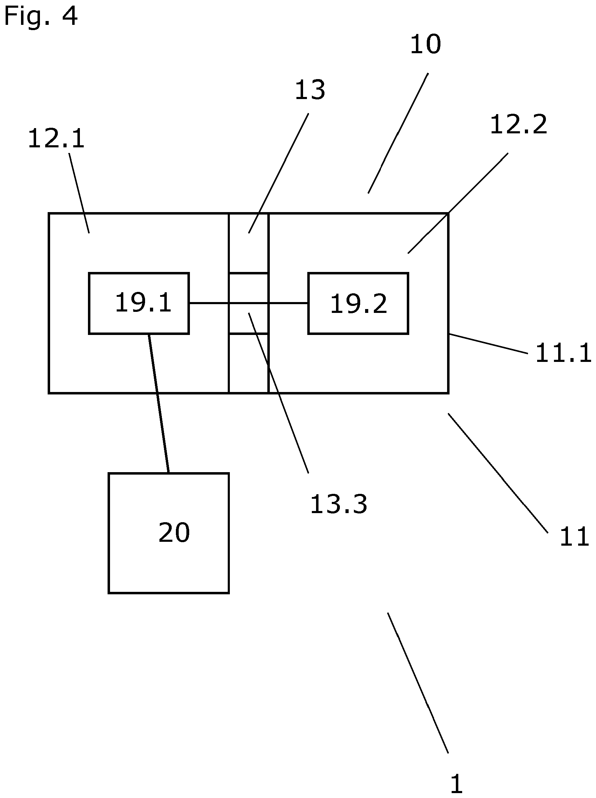

Fig. 4 zeigt einen schematischen Aufbau eines Feldgeräts mit einem erfindungsgemäßen Gehäusemodul.

Fig. 1 skizziert einen Querschnitt durch ein Gehäusemodul 10 eines Feldgeräts 1 der Mess- und Automatisierungstechnik mit einem Gehäuse 11 mit einer Gehäusewandung 11.1, welches Gehäuse eine erste Gehäusekammer 12.1 und eine zweite Gehäusekammer 12.2 umfasst, welche durch eine Trennwand 13 getrennt sind. Die Trennwand weist eine Durchgangsöffnung 13.4 auf.

In der ersten Gehäusekammer 12.1 ist eine Mess-/Betriebselektronik 16.1 angeordnet, und in der zweiten Gehäusekammer ist eine Anschlusselektronik 16.2 angeordnet. Die Mess-/Betriebselektronik ist dazu eingerichtet, Messsignale eines Messumformers aufzunehmen und Messwerte zu einer durch die Messsignale repräsentierten Messgröße bereitzustellen. Die Anschlusselektronik ist beispielsweise dazu eingerichtet, ein Auslesen der Messwerte oder ein Anschließen einer Versorgungsleitung zu ermöglichen. Die Mess-/Betriebselektronik und die Anschlusselektronik sind mittels einer elektrischen Durchführung 13.3 verbunden, welche elektrische Durchführung in der Durchgangsöffnung angeordnet ist. Die Trennung der ersten Gehäusekammer von der zweiten Gehäusekammer erfüllt dabei die Ex-d-Norm nach IEC60079-1 von 2014-06; EN60079-1 von 2014-06, wobei die Trennwand sowie die in die Durchgangsöffnung eingesetzte elektrische Durchführung eine Flammendurchschlagssperre bilden.

Die Gehäusewandung weist auf einer Innenseite 11.11 einen ersten Wandungsbereich 11.21 eingerichtet zur Aufnahme der Trennwand auf, wobei der erste Wandungsbereich von einer Mantelfläche 13.5 der Trennwand durch einen die Trennwand umgebenden Spalt 18 getrennt ist (siehe vergrößerter Ausschnitt), wobei der Spalt in einer einen Längsschnitt der Trennwand enthaltende Ebene eine Pfadlänge aufweist, wobei ein Verhältnis Spaltbreite zu Pfadlänge kleiner ist als kleiner ist als 0.05, und insbesondere kleiner ist als 0.025 und bevorzugt ist kleiner als 0.02 und der Ex-d-Norm nach IEC60079-1 von 2014-06; EN60079-1 von 2014-06 entspricht. Eine Sicherungsvorrichtung 14 ist dazu vorgesehen, einen Bewegungsspielraum der Trennwand in Richtung zweite Gehäusekammer einzuschränken. Die Gehäusewandung weist auf der Innenseite einen zweiten Wandungsbereich 11.22 auf, in welchem zweiten Wandungsbereich die Gehäusewandung zumindest abschnittsweise zumindest eine Nut 11.3 aufweist, welche Nut parallel zu einer Querschnittsebene der Trennwand verläuft. Die Sicherungsvorrichtung umfasst erfindungsgemäß eine Eingriffsvorrichtung 14.1, welche dazu eingerichtet ist, mittels mindestens zweier Eingriffselemente 14.2 in die Nut einzugreifen. Die Eingriffselemente werden bei Montage der Sicherungsvorrichtung in der zweiten Gehäusekammer mittels dazu vorgesehener Führungskörper von einer Ausgangsposition 16.1 in eine Zielposition 16.2 (siehe Figs. 2 a) und 2 b)) in eine zugehörige Nut geführt, siehe dazu Figs. 2 a) und 2 b).

Die Montage umfasst dabei ein Verschrauben der Sicherungsvorrichtung mit der Trennwand, wobei Schrauben 17, siehe Figs. 3 a) und b) in dafür vorgesehene Bohrungen in der Trennwand eingreifen.

Figs. 2 a) und 2 b) zeigt eine Aufsicht auf eine der ersten Gehäusekammer zuzuwendende Seite der Sicherungsvorrichtung 14 mit einer Eingriffsvorrichtung 14.1, welche Eingriffsvorrichtung drei Eingriffselemente 14.2 aufweist, wobei die Eingriffselemente in Fig. 2 a) sich in der Ausgangsposition und in Fig. 2 b) sich in einer Zielposition befinden. Die Sicherungsvorrichtung umfasst des Weiteren eine Haltevorrichtung 14.3 mit einem Grundkörper 14.4, welche dazu eingerichtet ist, die Eingriffselemente in der Ausgangsposition beweglich zu halten, und wobei die Haltevorrichtung dazu eingerichtet ist, die Eingriffselemente bei Montage in die Zielposition zu führen. Die Eingriffselemente werden bei Montage gegen die Trennwand gedrückt und mittels dazu vorgesehener Führungskörper von der Ausgangsposition in die Endposition geführt, welche Führungskörper jeweils eine Bewegungsfreiheit des zugehörigen Eingriffselements beschränken.

Jedes Eingriffselement 14.2 zwei Einschnitte 14.21 mit jeweils einem ersten, der zugehörigen Nut zugewandten Einschnittende 14.211 und einem zweiten, der zugehörigen Nut abgewandten Einschnittende 14.212 auf. Die Anzahl der Einschnitte ist hierbei beispielhaft und nicht beschränkend auszulegen.

Die Haltevorrichtung weist für jedes Eingriffselement zwei erste Führungskörper 14.5 mit jeweils einem Führungskopf 14.51 auf, welche Führungsköpfe jeweils eine erste schräge Fläche 14.511 aufweisen, wobei die ersten Führungskörper das zugehörige Eingriffselement von einer der Ausgangsposition zugewandten Seite des Eingriffselements im Bereich des zugehörigen Einschnitts umgreifen. Die Führungsköpfe 14.51 greifen dabei jeweils in einen zugehörigen Einschnitt ein und bewirken über das zweite Einschnittende eine Führung des Eingriffselements, wobei der Führungskopf auf einer dem zugehörigen zweiten Einschnittende eine erste schräge Fläche 14.511 aufweist, welche bezüglich der Querschnittsebene der Trennwand schräg verläuft, wobei die erste schräge Fläche dazu eingerichtet ist, bei Bewegung des Eingriffselements in seine Zielposition der Bewegung eine Komponente in Richtung des Grundkörpers zu vermitteln.

Die Haltevorrichtung weist für jedes Eingriffselement zwei seitlich zum jeweiligen Eingriffselement angeordnete zweiten Führungskörper 14.6 auf, welche zweiten Führungskörper aus dem Grundkörper hervorstehen und jeweils mindestens eine zweite schräge Fläche 14.61 aufweisen, welche zweite schräge Fläche bezüglich der Querschnittsebene der Trennwand schräg verlaufen. Die zweite schräge Fläche ist dazu eingerichtet, bei Bewegung eines zugehörigen Eingriffselements in seine Zielposition der Bewegung eine Komponente parallel zur Querschnittsfläche der Trennwand in Richtung der Gehäusewandung zu vermitteln.

Die Kombination von ersten Führungskörpern und zweiten Führungskörpern zwingt den Eingriffselementen somit jeweils eine definierte Bewegung entlang einer Trajektorie auf, welche Bewegung durch Andrücken der Eingriffselemente gegen die Trennwand verursacht wird.

Figs. 3 a) und 3 b) zeigen jeweils eine Aufsicht auf die Figs. 1 und 2 a) und 2 b) gezeigte Sicherungsvorrichtung mit Eingriffselementen in Zielposition aus zwei gegenüberliegenden Richtungen, wobei Schrauben 17 durch jeweils eine Bohrung in der Haltevorrichtung sowie eine zugehörige Durchgangsbohrung geführt sind. Das Durchführen der Schrauben durch beide zugehörigen Bohrungen ist nur bei Eingriffselementen 14.2 in Zielposition möglich, da erst dann die Bohrungen der Haltevorrichtungen und zugehörige Durchgangsbohrungen 14.23 der Eingriffselemente 14.2 koaxial sind. Bevorzugt weist die Haltevorrichtung 14.3 wie in Fig. 3 b) gezeigt für jede Schraube eine Aufnahmevorrichtung auf, in welcher ein Schraubenkopf 17.1 der Schraube bei Montage versenkbar ist und somit eine optische Rückmeldung bei korrekter Montage der Sicherungsvorrichtung gegeben ist.

Fig. 4 skizziert einen schematischen beispielhaften Aufbau eines Feldgeräts 1 der Mess- und Automatisierungstechnik, welches ein erfindungsgemäßes Gehäusemodul 10 mit einem Gehäuse 11 aufweist, welches Gehäuse durch eine Gehäusewand 11.1 ausgebildet wird. Das Gehäusemodul weist eine erste Gehäusekammer 12.1 und eine zweite Gehäusekammer 12.2 auf, welche durch eine Trennwand 13 getrennt sind. Die Trennwand kann dabei lösbar befestigt eingerichtet sein. In der ersten Gehäusekammer ist eine elektronische Mess-/Betriebsschaltung 16.1 angeordnet, welche dazu eingerichtet ist, einen Messumformer 20 des Feldgeräts zu betreiben, und in der zweiten Gehäusekammer ist eine Anschlusselektronik 16.2 angeordnet. Eine erfindungsgemäße Durchführung 14 wie oben beschrieben ist dazu eingerichtet, die Mess-/Betriebselektronik mit der Anschlusselektronik elektrisch zu verbinden.

### Bezugszeichenliste

- 1: Feldgerät
- 10: Gehäusemodul
- 11: Gehäuse
- 11.1: Gehäusewandung
- 11.11: Innenseite der Gehäusewandung
- 11.21: erster Wandungsbereich
- 11.22: zweiter Wandungsbereich
- 11.3: Nut
- 12.1: erste Gehäusekammer
- 12.2: zweite Gehäusekammer
- 13: Trennwand
- 13.1: erste Bohrung
- 13.2: Aussparung
- 13.3: Durchführung
- 13.4: Durchgangsöffnung
- 13.5: Mantelfäche der Trennwand
- 14: Sicherungsvorrichtung
- 14.1: Eingriffsvorrichtung
- 14.2: Eingriffselemente
- 14.21: Einschnitt
- 14.211: erstes Einschnittende
- 14.212: zweites Einschnittende
- 14.23: Durchgangsbohrung
- 14.3: Haltevorrichtung
- 14.31: Aufnahmevorrichtung
- 14.4: Grundkörper
- 14.5: erster Führungskörper
- 14.51: Führungskopf
- 14.511: erste schräge Fläche
- 14.6: zweiter Führungskörper
- 14.61: zweite schräge Fläche
- 15: Befestigungsvorrichtung
- 16.1: Ausgangsposition
- 16.2: Zielposition
- 17: Schraube
- 17.1: Schraubenkopf
- 17.2: Schraubenschaft
- 18: Spalt
- 19.1: Mess-/Betriebselektronik
- 19.2: Anschlusselektronik
- 20: Messumformer

## Patentansprüche

1. Gehäusemodul (10) eines Feldgeräts (1) der Mess- und Automatisierungstechnik umfassend:
ein Gehäuse (11) mit einer Gehäusewandung (11.1) und einer ersten Gehäusekammer (12.1) sowie einer zweiten Gehäusekammer (12.2), wobei die Gehäusekammern durch
eine lösbar befestigte Trennwand (13) getrennt sind,
wobei in der ersten Gehäusekammer eine Mess-/Betriebselektronik (19.1) des Feldgeräts angeordnet ist, und wobei in der zweiten Gehäusekammer eine Anschlusselektronik (19.2) zum Anschließen von Leitungen zur Energieversorgung des Feldgeräts und/oder zum Austausch von Daten angeordnet ist,
wobei die Gehäusewandung auf einer Innenseite (11.11) einen ersten Wandungsbereich (11.21) eingerichtet zur Aufnahme der Trennwand aufweist, wobei der erste Wandungsbereich von einer Mantelfläche (13.5) der Trennwand durch einen die Trennwand umgebenden Spalt (18) getrennt ist, wobei der Spalt in einer einen Längsschnitt der Trennwand enthaltende Ebene eine Pfadlänge aufweist,
wobei ein Verhältnis Spaltbreite zu Pfadlänge kleiner ist als 0.05, und insbesondere kleiner ist als 0.025 und bevorzugt kleiner ist als 0.02 und der EX-d-Norm nach IEC60079-1 von 2014-06, EN60079-1 von 2014-06 entspricht,
wobei eine Sicherungsvorrichtung (14) dazu vorgesehen ist, einen Bewegungsspielraum der Trennwand in Richtung zweite Gehäusekammer einzuschränken,
**dadurch gekennzeichnet, dass** die Gehäusewandung auf der Innenseite einen zweiten Wandungsbereich (11.22) aufweist, wobei in dem zweiten Wandungsbereich die Gehäusewandung zumindest abschnittsweise zumindest eine Nut (11.3) aufweist, wobei die Nut parallel zu einer Querschnittsebene der Trennwand verläuft,
wobei die Sicherungsvorrichtung eine Eingriffsvorrichtung (14.1) aufweist, welche dazu eingerichtet ist, in die Nut einzugreifen,
wobei die Eingriffsvorrichtung mindestens zwei Eingriffselemente (14.2) aufweist,
wobei die Eingriffselemente bei Montage der Sicherungsvorrichtung in der zweiten Gehäusekammer von einer Ausgangsposition (16.1) in eine Zielposition (16.2) in eine zugehörige Nut geführt werden,
wobei die Eingriffselemente in der Zielposition mittels einer Befestigungsvorrichtung (15) fixierbar sind.

2. Gehäusemodul nach Anspruch 1,
wobei die Sicherungsvorrichtung eine Haltevorrichtung (14.3) mit einem Grundkörper (14.4) aufweist, welche dazu eingerichtet ist, die Eingriffselemente in der Ausgangsposition beweglich zu halten, und wobei die Haltevorrichtung dazu eingerichtet ist, die Eingriffselemente bei Montage in die Zielposition zu führen.

3. Gehäusemodul nach Anspruch 2,
wobei jedes Eingriffselement (14.2) zumindest einen Einschnitt, insbesondere mindestens zwei Einschnitte (14.21) mit jeweils einem ersten, der zugehörigen Nut zugewandten Einschnittende (14.211) und einem zweiten, der zugehörigen Nut abgewandten Einschnittende (14.212) aufweist,
wobei die Haltevorrichtung für jeden Einschnitt mindestens einen ersten Führungskörper (14.5) aufweist, wobei die ersten Führungskörper das zugehörige Eingriffselement von einer der Ausgangsposition zugewandten Seite des Eingriffselements im Bereich des zugehörigen Einschnitts umgreifen,
wobei jeder erste Führungskörper einen Führungskopf (14.51) aufweist, wobei der Führungskopf in den zugehörigen Einschnitt eingreift und dazu eingerichtet ist, über das zweite Einschnittende eine Führung des Eingriffselements zu bewirken.

4. Gehäusemodul nach Anspruch 3,
wobei der Führungskopf auf einer dem zugehörigen zweiten Einschnittende eine erste schräge Fläche (14.511) aufweist, welche bezüglich der Querschnittsebene der Trennwand schräg verläuft,
wobei die erste schräge Fläche dazu eingerichtet ist, bei Bewegung des Eingriffselements in seine Zielposition der Bewegung eine Komponente in Richtung des Grundkörpers zu vermitteln.

5. Gehäusemodul nach einem der Ansprüche 2 bis 4,
wobei die Haltevorrichtung für jedes Eingriffselement mindestens einen zweiten Führungskörper (14.6) aufweist, wobei der zweite Führungskörper aus dem Grundkörper hervorsteht und jeweils mindestens eine zweite schräge Fläche (14.61) aufweist,
wobei die zweite schräge Fläche bezüglich der Querschnittsebene der Trennwand schräg verläuft,
wobei die zweite schräge Fläche dazu eingerichtet ist, bei Bewegung eines zugehörigen Eingriffselements in seine Zielposition der Bewegung eine Komponente parallel zur Querschnittsfläche der Trennwand in Richtung der Gehäusewandung zu vermitteln.

6. Gehäusemodul nach einem der vorigen Ansprüche,
wobei die Trennwand für jedes Eingriffselement mindestens eine erste Bohrung (13.1) mit einem Innengewinde aufweist,
wobei die Eingriffselemente jeweils eine Durchgangsbohrung (14.23) aufweisen, wobei die Durchgangsbohrungen bei Positionierung der Eingriffselemente in ihren Zielpositionen jeweils koaxial zu einer ersten Bohrung sind,
wobei die Eingriffselemente mittels Schrauben (17) in der Zielposition fixiert sind,
wobei die Schrauben jeweils in das Innengewinde einer ersten Bohrung eingreifen.

7. Gehäusemodul nach Anspruch 6,
wobei die Haltevorrichtung für jede Schraube eine Aufnahmevorrichtung (14.31) zur Aufnahme eines Schraubenkopfs (17.1) der jeweiligen Schraube aufweist,
wobei bei Fixieren eines Eingriffselements in seiner Zielposition mittels einer Schraube der Schraubenkopf der jeweiligen Schraube in der Aufnahmevorrichtung versenkt wird.

8. Gehäusemodul nach einem der vorigen Ansprüche,
wobei die Haltevorrichtung (14.3) mittels Spritzgießen aus einem Kunststoff gefertigt ist.

9. Gehäusemodul nach einem der vorigen Ansprüche,
wobei die Eingriffselemente (14.2) jeweils aus einem Metall oder einer Legierung wie Stahl gefertigt sind.

10. Gehäusemodul nach einem der Ansprüche 3 bis 9,
wobei die Trennwand zumindest eine Aussparung (13.2) aufweist, welche dazu eingerichtet ist, die ersten Führungskörper zumindest teilweise aufzunehmen.

11. Gehäusemodul nach einem der vorigen Ansprüche,
wobei die Trennwand eine Durchführung (13.3) eingerichtet für eine elektrische Verbindung zwischen Mess-/Betriebselektronik und Anschlusselektronik aufweist,
wobei die Durchführung in einer Durchgangsöffnung (13.4) der Trennwand angeordnet ist.

12. Feldgerät (1) der Mess- und Automatisierungstechnik umfassend:
Ein Gehäusemodul (10) nach einem der vorigen Ansprüche;
Einen Messumformer (20) zum Erfassen mindestens einer Messgröße und zum Bereitstellen eines die Messgröße repräsentierenden Messsignals,
wobei die Mess-/Betriebselektronik (19.1) dazu eingerichtet ist, mittels des Messsignals Messwerte der Messgröße zu bestimmen und bereitzustellen.

## Claims

1. Housing module (10) of a field device (1) used in measuring and automation engineering, comprising:
a housing (11) with a housing wall (11.1) and a first housing chamber (12.1) and a second housing chamber (12.2), wherein the housing chambers are separated by a detachable partition wall (13),
wherein a measuring/operating electronics unit (19.1) of the field device is arranged in the first housing chamber, and wherein a connection electronics unit (19.2) to connect cables for the supply of power to the field device and/or for the exchange of data is arranged in the second housing chamber,
wherein, on an inside (11.11), the housing wall has a first wall section (11.21) designed to receive the partition wall, wherein the first wall section is separated from a lateral surface (13.5) of the partition wall by a gap (18) surrounding the partition wall, wherein the gap has a path length on a plane containing a longitudinal section of the partition wall,
wherein a ratio of the gap width to the path length is less than 0.05, and particularly less than 0.025 and preferably less than 0.02 and meets the EX-d standard according to IEC60079-1 of 2014-06, EN60079-1 of 2014-06,
wherein a safety apparatus (14) is provided to limit the leeway the partition wall has to move in the direction of the second housing chamber,
**characterized in that** the housing wall has a second wall section (11.22) on the inside wherein, in the second housing section, the housing wall has at least a groove (11.3) at least in sections,
wherein the groove runs parallel to a cross-sectional plane of the transition wall,
wherein the safety apparatus has an engagement unit (14.1) which is designed to engage in the groove,
wherein the engagement unit has at least two engagement elements (14.2)
wherein the engagement elements are guided into an associated groove, going from a starting position (16.1) to a target position (16.2) when the safety apparatus is mounted in the second housing chamber,
wherein the engagement elements can be fixed in the target position by a fastening apparatus (15).

2. Housing module as claimed in Claim 1,
wherein the safety apparatus has a retaining unit (14.3) with a base body (14.4) which is designed to flexibly hold the engagement elements in the starting position, and wherein the retaining unit is designed to guide the engagement elements into the target position when mounting.

3. Housing module as claimed in Claim 3,
wherein each engagement element (14.2) has at least one recess, particularly at least two recesses (14.21) each with a first recess end (14.211), facing towards the associated groove, and a second recess end (14.212) facing away from the associated groove,
wherein, for each recess, the retaining unit has at least a first guide body (14.5), wherein the first guide bodies surround the associated engagement element from a side of the engagement element facing towards the starting position in the area of the associated recess, wherein each first guide body has a guide head (14.51), wherein the guide head engages in the associated recess and is designed to bring about the guiding of the engagement element via the second recess end.

4. Housing module as claimed in Claim 3,
wherein the guide head has a first inclined surface (14.511) on the associated second recess end, which runs at an angle in relation to the cross-sectional plane of the partition wall,
wherein the first inclined surface is designed to determine the movement of a component in the direction of the base body when the engagement element moves.

5. Housing module as claimed in one of the Claims 2 to 4,
wherein the retaining unit for each engagement element has at least a second guide body (14.6), wherein the second guide body projects out of the base body and, in each case, has at least a second inclined surface (14.61),
wherein the second inclined surface runs at an angle in relation to cross-sectional plane of the partition wall,
wherein the second inclined surface is designed to determine the movement of a component parallel to the cross-sectional area of the partition wall in the direction of the housing wall when the associated engagement element moves into its target position.

6. Housing module as claimed in one of the previous claims,
wherein the partition wall has at least a first bore (13.1) with a female thread for each engagement element,
wherein the engagement elements each have a through bore (14.23), wherein the through bores are each in a coaxial position in relation to a first bore when the engagement elements are positioned in their target positions,
wherein the engagement elements are fixed in the target position using screws (17),
wherein the screws engage, in each case, in the female thread of a first bore.

7. Housing module as claimed in Claim 6,
wherein, for each screw, the retaining unit has a cradle (14.31) to hold a screw head (17.1) of the screw,
wherein, when an engagement element is fixed in its target position using a screw, the screw head of the screw is sunk in the cradle.

8. Housing module as claimed in one of the previous claims,
wherein the retaining unit (14.3) is manufactured from a plastic using injection molding.

9. Housing module as claimed in one of the previous claims,
wherein the engagement elements (14.2) are each made from a metal or an alloy such as steel.

10. Housing module as claimed in one of the Claims 3 to 9,
wherein the partition wall has at least an opening (13.2), which is designed to at least partially accommodate the first guide bodies.

11. Housing module as claimed in one of the previous claims,
wherein the partition wall has a feedthrough (13.3) for an electrical connection between the measuring/operating electronics unit and the connection electronics unit,
wherein the feedthrough is arranged in a through-opening (13.4) of the partition wall.

12. Field device (1) used in measuring and automation engineering,
comprising:
a housing module (10) as claimed in one of the previous claims;
a transmitter (20) for recording at least a measured variable and to provide a measuring signal representing the measuring/operating electronics unit (19.1),
wherein the measuring/operating electronics unit (19.1) is designed to determine and provide measured values of the measured variable using the measuring signal.

## Revendications

1. Module de boîtier (10) d'un appareil de terrain de la technique de mesure et d'automatisation, lequel module comprend :
un boîtier (11) avec une paroi de boîtier (11.1) et une première chambre de boîtier (12.1) ainsi qu'une deuxième chambre de boîtier (12.2), les chambres de boîtier étant séparées par une paroi de séparation (13) fixée de manière amovible,
une électronique de mesure/d'exploitation (19.1) de l'appareil de terrain étant disposée dans la première chambre de boîtier, et une électronique de raccordement (19.2) - destinée au raccordement de câbles pour l'alimentation en énergie de l'appareil de terrain et/ou pour l'échange de données - étant disposée dans la deuxième chambre de boîtier,
la paroi de boîtier présentant sur une face intérieure (11.11) une première zone de paroi (11.21) destinée à recevoir la paroi de séparation, la première zone de paroi étant séparée d'une surface d'enveloppe (13.5) de la paroi de séparation par une fente (18) entourant la paroi de séparation, la fente présentant une longueur de chemin dans un plan contenant une coupe longitudinale de la paroi de séparation,
un rapport entre la largeur de fente et la longueur de chemin étant inférieur à 0,05, et notamment inférieur à 0,025 et de préférence inférieur à 0,02 et correspondant à la norme Ex-d selon IEC60079-1 de 2014-06, EN60079-1 de 2014-06,
un dispositif de sécurité (14) étant prévu pour limiter un espace de mouvement de la paroi de séparation en direction de la deuxième chambre de boîtier,
**caractérisé en ce que** la paroi de boîtier présente sur la face intérieure une deuxième zone de paroi (11.22), la paroi de boîtier présentant dans la deuxième zone de paroi, au moins par sections, au moins une rainure (11.3), la rainure s'étendant parallèlement à un plan de section transversale de la paroi de séparation,
le dispositif de sécurité présentant un dispositif d'engagement (14.1), lequel est conçu pour s'engager dans la rainure,
le dispositif d'engagement comprenant au moins deux éléments d'engagement (14.2),
les éléments d'engagement étant guidés dans une rainure associée d'une position initiale (16.1) à une position cible (16.2) lors du montage du dispositif de sécurité dans la deuxième chambre de boîtier,
les éléments d'engagement pouvant être fixés dans la position cible au moyen d'un dispositif de fixation (15).

2. Module de boîtier selon la revendication 1,
pour lequel le dispositif de sécurité présente un dispositif de retenue (14.3) avec un corps de base (14.4), lequel dispositif de retenue est conçu pour maintenir les éléments d'engagement de manière mobile dans la position initiale, et
pour lequel le dispositif de retenue est conçu pour guider les éléments d'engagement dans la position cible lors du montage.

3. Module de boîtier selon la revendication 2,
pour lequel chaque élément d'engagement (14.2) présente au moins une encoche, notamment au moins deux encoches (14.21) avec respectivement une première extrémité d'encoche (14.211) tournée vers la rainure associée et une deuxième extrémité d'encoche (14.212) opposée à la rainure associée, le dispositif de retenue présentant pour chaque encoche au moins un premier corps de guidage (14.211) et au moins un deuxième corps de guidage (14.212), le dispositif de retenue présentant pour chaque encoche au moins un deuxième corps de guidage (14.212). 5), les premiers corps de guidage entourant l'élément d'engagement associé à partir d'un côté de l'élément d'engagement tourné vers la position initiale dans la zone de l'encoche associée, chaque premier corps de guidage comportant une tête de guidage (14.51), la tête de guidage s'engageant dans l'encoche associée et étant conçue pour assurer un guidage de l'élément d'engagement par l'intermédiaire de la deuxième extrémité d'encoche.

4. Module de boîtier selon la revendication 3,
pour lequel la tête de guidage présente, sur une extrémité de la deuxième encoche correspondante, une première surface inclinée (14.511) qui s'étend de manière inclinée par rapport au plan de la section transversale de la paroi de séparation,
la première surface inclinée étant conçue, lors du déplacement de l'élément d'engagement vers sa position cible, pour transmettre au déplacement une composante en direction du corps de base.

5. Module de boîtier selon l'une des revendications 2 à 4,
pour lequel le dispositif de retenue présente pour chaque élément d'engagement au moins un deuxième corps de guidage (14.6), le deuxième corps de guidage dépassant du corps de base et présentant respectivement au moins une deuxième surface inclinée (14.61),
la deuxième surface inclinée étant inclinée par rapport au plan de la section transversale de la paroi de séparation,
la deuxième surface inclinée étant conçue, lors du déplacement d'un élément d'engagement associé dans sa position cible, pour transmettre au déplacement une composante parallèle au plan de section transversale de la paroi de séparation en direction de la paroi du boîtier.

6. Module de boîtier selon l'une des revendications précédentes,
pour lequel la paroi de séparation présente pour chaque élément d'engagement au moins un premier alésage (13.1) avec un filetage intérieur, les éléments d'engagement présentant chacun un alésage traversant (14.23), les alésages traversants étant respectivement coaxiaux à un premier alésage lors du positionnement des éléments d'engagement dans leurs positions cibles, les éléments d'engagement étant fixés dans la position cible au moyen de vis (17), les vis s'engageant respectivement dans le filetage intérieur d'un premier alésage.

7. Module de boîtier selon la revendication 6,
pour lequel le dispositif de retenue pour chaque vis présente un dispositif de réception (14.31) destiné à recevoir une tête de vis (17.1) de la vis respective, la tête de vis respective étant noyée dans le dispositif de réception lors de la fixation d'un élément d'engagement dans sa position cible au moyen d'une vis.

8. Module de boîtier selon l'une des revendications précédentes,
pour lequel le dispositif de retenue (14.3) est fabriqué à partir d'une matière plastique par moulage par injection.

9. Module de boîtier selon l'une des revendications précédentes,
pour lequel les éléments d'engagement (14.2) sont chacun fabriqués à partir d'un métal ou d'un alliage tel que l'acier.

10. Module de boîtier selon l'une des revendications 3 à 9,
pour lequel la paroi de séparation comporte au moins un évidement (13.2), lequel est prévu pour recevoir au moins partiellement les premiers corps de guidage.

11. Module de boîtier selon l'une des revendications précédentes,
pour lequel la paroi de séparation comporte un passage (13.3) prévu pour une liaison électrique entre l'électronique de mesure/d'exploitation et l'électronique de raccordement, le passage étant disposé dans une ouverture de passage (13.4) de la paroi de séparation.

12. Appareil de terrain de la technique de mesure et d'automatisation, lequel appareil comprend :
Un module de boîtier (10) selon l'une des revendications précédentes ;
Un transmetteur (20) destiné à mesurer au moins une grandeur de mesure et à mettre à disposition un signal de mesure représentant la grandeur de mesure, l'électronique de mesure/d'exploitation (19.1) étant conçue pour déterminer et mettre à disposition des valeurs mesurées de la grandeur de mesure au moyen du signal de mesure.
